# EUROPEAN PATENT APPLICATION

(11) **EP 2 555 602 A1**
(43) Date of publication of application: **06.02.2013**
(21) Application number: 11854015.2
(22) Date of filing: 09.12.2011
(51) Int. Cl.: H05K 3/46, H01L 23/12, H05K 1/11, H05K 3/40

(54) **MULTILAYER WIRING BOARD AND METHOD FOR MANUFACTURING MULTILAYER WIRING BOARD**

(30) Priority: 29.12.2010 JP 2010294439
(71) Applicant: Panasonic Corporation, Osaka 571-8501 (JP)
(72) Inventor: HIGUCHI, Takayuki, Osaka 540-6207 (JP); HIRAI, Shogo, Osaka 540-6207 (JP); HIMORI, Tsuyoshi, Osaka 540-6207 (JP); ISHITOMI, Hiroyuki, Osaka 540-6207 (JP)
(74) Representative: TBK
(86) International application number: PCT/JP2011/006885
(87) International publication number: WO 2012/090402

(57) **Abstract**

Disclosed is a multilayer wiring board having via-hole conductors for connecting a first copper wiring and a second copper wiring, the via-hole conductor including a metal portion and a resin portion. The metal portion includes a first metal region including a link of copper particles as a path for electrically connecting the first and second copper wirings; a second metal region mainly composed of at least one selected from tin, a tin-copper alloy, and a tin-copper intermetallic compound; and a third region mainly composed of bismuth. The copper particles forming the link are in plane-to-plane contact with one another. At least one of the first copper wiring and the second copper wiring is in plane-to-plane contact with the copper particles, and the portion where there is such a plane-to-plane contact is covered with at least a part of the second metal region.

## Description

### [Technical Field]

The present invention relates to a multilayer wiring board including via-hole conductors serving as an interlayer connection between two wirings formed three-dimensionally on an insulating resin layer. Specifically, the present invention relates to enhancing connection reliability of via-hole conductors serving as an interlayer connection between multilayer wirings.

### [Background Art]

A conventionally-known multilayer wiring board is obtained by creating an interlayer connection between two wirings formed three-dimensionally on an insulating resin layer. Known as a way to create such an interlayer connection, is use of via-hole conductors which are formed by filling holes created in the insulating resin layer, with a conductive paste. Also known are via-hole conductors which are formed by filling with metal particles containing copper (Cu), in place of a conductive paste, and then fixing the metal particles to one another with use of an intermetallic compound. Also known is a method in which a solder layer is disposed between a wiring and a via-hole conductor to enable a stronger connection and thus a more enhanced connection reliability therebetween.

Specifically, for example, Patent Literature 1 below discloses via-hole conductors having a matrix-domain structure, in which domains of Cu particles are interspersed throughout a CuSn compound matrix.

Also, for example, Patent Literature 2 below discloses a sinterable composition for use in forming via-hole conductors, the composition including: a high-melting-point particle-phase material that includes Cu; and a low-melting-point material selected from metals such as tin (Sn) and tin alloys. The above sinterable composition is sintered in the presence of a liquid phase or a transient liquid phase.

Also, for example, Patent Literature 3 below discloses a via-hole conductor material in which an alloy layer with a solidus temperature of 250°C or higher is formed around the outer surface of copper particles, by heating a conductive paste containing tin-bismuth (Sn-Bi) metal particles and copper particles at a temperature equal to or higher than the melting point of the Sn-Bi metal particles. Such a via-hole conductor material is described as achieving high connection reliability, since interlayer connection is created by the alloy layers with a solidus temperature of 250°C or higher being joined to one another, thus preventing the alloy layers from melting even during heat cycling tests and reflow resistance tests.

Also, for example, Patent Literature 4 below discloses a multilayer wiring board including via-hole conductors each including: 80 to 97 wt% of copper and tin, in total; and 3 to 20 wt% of bismuth.

Also, for example, Patent Literature 5 below discloses a multilayer wiring board in which a very small amount of solder is disposed as a layer at the interface between: a conductive paste serving as a via-hole conductor; and an electrode of a wiring. The above results in forming a layer serving as a metallic joint between the conductive paste and the electrode, thereby improving conductivity.

### [Citation List]

### [Patent Literatures]

[Patent Literature 1] Japanese Laid-Open Patent Publication No. 2000-49460
[Patent Literature 2] Japanese Laid-Open Patent Publication No. Hei 10-7933
[Patent Literature 3] Japanese Laid-Open Patent Publication No. 2002-94242
[Patent Literature 4] Japanese Laid-Open Patent Publication No. 2002-290052
[Patent Literature 5] Japanese Laid-Open Patent Publication No. 2009-147026

### [Summary of Invention]

### [Technical Problem]

The via-hole conductor disclosed in Patent Literature 1 will be described in detail, with reference to Fig. 10. Fig. 10 is a schematic sectional view of the portion where a wiring 1 and a via-hole conductor 2 are connected to each other, in the multilayer wiring board disclosed in Patent Literature 1.

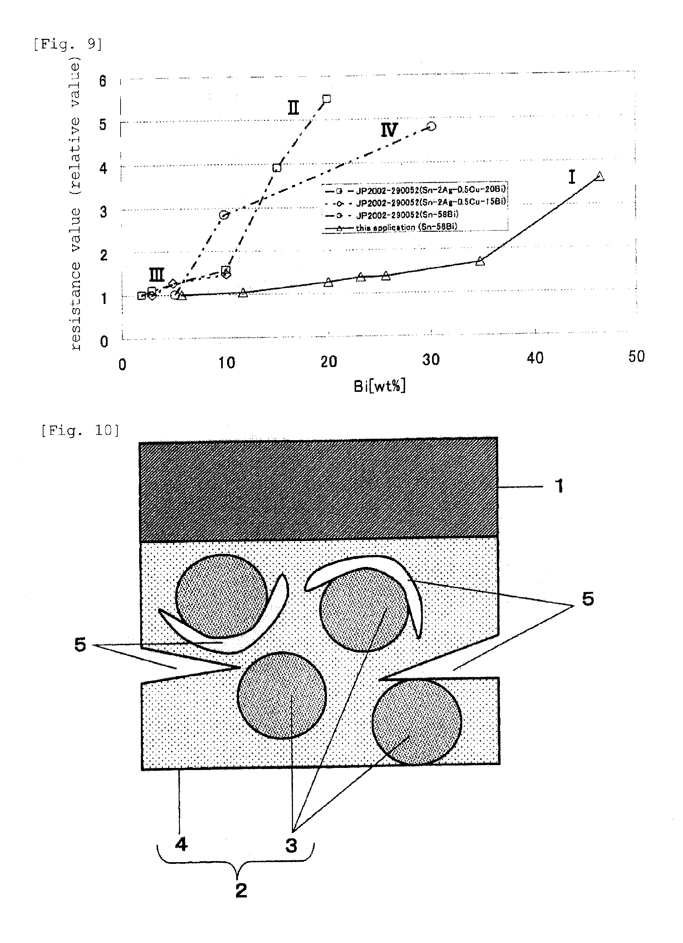

In the schematic sectional view of Fig. 10, the via-hole conductor 2 is in contact with the wiring 1 formed on the multilayer wiring board surface. The via-hole conductor 2 comprises: a matrix including an intermetallic compound 4 such as Cu₃Sn or Cu₆Sn₅; and copper-containing powder 3 interspersed as domains throughout the matrix including the intermetallic compound 4. In the via-hole conductor 2, the matrix-domain structure is formed by controlling the weight ratio represented by Sn/(Cu + Sn) to be in the range of 0.25 to 0.75. However, the above via-hole conductor 2 has the problem of being prone to voids or cracks (Ref. No. 5 in Fig. 10) during thermal shock tests.

The above voids or cracks are caused by a CuSn compound such as Cu₃Sn or Cu₆Sn₅ produced due to Cu diffusing into Sn-Bi metal particles when the via-hole conductor 2 is exposed to heat, during, for example, thermal shock tests or reflow processing. The above voids or cracks are also caused by internal stress generated inside the via-hole conductor 2, due to Cu₃Sn, which is an intermetallic compound of Cu and Sn included in Cu-Sn diffusion-bonded joints formed at the Cu/Sn interface, changing to Cu₆Sn₅ by heating performed during various reliability tests.

Also, the sinterable composition disclosed in Patent Literature 2 is sintered in the presence or absence of a transient liquid phase, that is generated, for example, during hot pressing performed to laminate prepregs. Use of the above sinterable composition would prove difficult to achieve Pb-free products as demanded by the market, since it includes Cu, Sn, and lead (Pb). It is also difficult to apply the above sinterable composition to a typical insulating resin layer that is obtained by impregnating glass fibers with epoxy resin (this may also be called a glass/epoxy resin layer), since it reaches a high temperature from 180°C to 325°C during hot pressing.

Also, in the via-hole conductor material disclosed in Patent Literature 3, the alloy layer formed on the surface of the Cu particles has high resistance. Therefore, there is the problem of higher resistance compared to connection resistance obtained only by contact among Cu particles or among Ag particles as in a typical conductive paste containing Cu particles, silver (Ag) powder, or the like.

In the via-hole conductor disclosed in Patent Literature 4 as well, the alloy layer formed on the surface of the Cu particles has high resistance. Therefore, there is the problem of not being able to obtain an interlayer connection with a sufficiently low resistance. This will be described later.

In the wiring board disclosed in Patent Literature 5 as well, although resistance is low in the via-hole conductor due to contact among the conductive particles, there is the problem of high resistance at the interface between the via-hole conductor and the electrode of the wiring, where the metallic joint is formed by the very small amount of solder disposed therebetween in layer form. Furthermore, stress tends to gather at the solder portion, since the wiring and the conductive particles are metallically joined by the solder without any space created therebetween. Therefore, there is the problem of the via-hole conductor being prone to cracks when it is exposed to heat, during, for example, thermal shock tests or reflow processing.

An object of the present invention is to provide a multilayer wiring board capable of meeting the need for being Pb-free, in which interlayer connections are achieved by low-resistance via-hole conductors with high connection reliability.

### [Solution to Problem]

One aspect of the present invention is directed to a multilayer wiring board comprising:
at least one insulating resin layer;
a first copper wiring disposed on a first surface of the insulating resin layer;
a second copper wiring disposed on a second surface of the insulating resin layer; and
via-hole conductors provided in a manner such that they penetrate through the insulating resin layer and electrically connect the first copper wiring and the second copper wiring,
wherein the via-hole conductor comprises a metal portion and a resin portion,
the metal portion comprising:
a first metal region including a link of copper particles which serves as a path for electrically connecting the first copper wiring and the second copper wiring;
a second metal region mainly composed of at least one metal selected from the group consisting of tin, a tin-copper alloy, and a tin-copper intermetallic compound; and
a third metal region mainly composed of bismuth,
the copper particles forming the link are in plane-to-plane contact with one another,
at least one of the first copper wiring and the second copper wiring is in plane-to-plane contact with the copper particle,
a surface of the first or second copper wiring in plane-to-plane contact with the copper particle is roughened, and
a portion where the first or second copper wiring is in plane-to-plane contact with the copper particle is covered with at least a part of the second metal region.

Also, another aspect of the present invention is directed to a method for producing a multilayer wiring board,
the multilayer wiring board comprising: at least one insulating resin layer; a first copper wiring disposed on a first surface of the insulating resin layer; a second copper wiring disposed on a second surface of the insulating resin layer; and via-hole conductors provided in a manner such that they penetrate through the insulating resin layer, the via-hole conductors electrically connecting the first copper wiring and the second copper wiring,
wherein the via-hole conductor comprises a metal portion and a resin portion, the metal portion comprising: a first metal region including a link of copper particles for serving as a path which electrically connects the first copper wiring and the second copper wiring; a second metal region mainly composed of at least one metal selected from the group consisting of tin, a tin-copper alloy, and a tin-copper intermetallic compound; and a third region mainly composed of bismuth,
the copper particles forming the link are in plane-to-plane contact with one another,
at least one of the first copper wiring and the second copper wiring is in plane-to-plane contact with the copper particle, and
a portion where the first or second copper wiring is in contact with the copper particle is covered with at least a part of the second metal region,
the method comprising:
a first step of covering a surface of an insulating resin sheet with a protective film;
a second step of perforating the insulating resin sheet having the protective film thereon, so as to create through-holes;
a third step of filling the through-holes with a via paste containing copper particles, tin-bismuth solder particles, and a thermally curable resin;
a fourth step of removing the protective film after the third step to reveal protrusions each formed by a part of the via paste protruding from the through-hole;
a fifth step of disposing copper foil on at least one surface of the insulating resin sheet in a manner such that it covers the protrusions;
a sixth step of compression bonding the copper foil onto the insulating resin sheet and compressing the via paste by way of the protrusions, thereby: allowing the copper foil and the copper particles to come into plane-to-plane contact; and allowing the copper particles to come into plane-to-plane contact with one another to form a first metal region including a link of the copper particles; and
a seventh step of melting a part of the tin-bismuth solder particles in the via paste after the sixth step, at a temperature in a range from the eutectic temperature of the tin-bismuth solder particles to the eutectic temperature plus 10°C, and then, heating further at a temperature in a range from the eutectic temperature plus 20°C to 300°C, thereby forming a second metal region and a third metal region.

The object, features, aspects, and advantages of the present invention will become more apparent by referring to the following detailed description and accompanying drawings.

### [Advantageous Effects of Invention]

According to the present invention, low-resistance interlayer connections can be achieved in the multilayer wiring board, by low-resistance conductive paths formed therein with the copper wirings and the copper particles included in the via-hole conductors; and further, with the link of the copper particles having the plane-to-plane contact portions, the portions being where the copper particles come into plane-to-plane contact with one another. Also, reliability of electrical connection is enhanced, by covering and thus strengthening, with at least a part of the second metal region, the portion where the first or second copper wiring and the copper particle come into plane-to-plane contact with one another. This is due to the second metal region being mainly composed of at least one selected from the group consisting of tin, a tin-copper alloy, and a tin-copper intermetallic compound that is harder than the copper particle.

### [Brief Description of Drawings]

Fig. 1A is a schematic sectional view of a multilayer wiring board 11 in a first embodiment.
Fig. 1B is an enlarged schematic sectional view showing the vicinity of a via-hole conductor 14 in Fig. 1A.
Fig. 2 is an explanatory drawing describing, with respect to the first embodiment, a link 17a of copper particles 7 serving as a conductive path 23 between two copper wirings, the link 17a being formed by the copper particles 7 coming into plane-to-plane contact with one another.
Fig. 3 is a schematic sectional view of the via-hole conductor when Cu/Sn is smaller than 1.59.
Fig. 4A is a sectional view of a step, describing, with respect to the first embodiment, one example of a method for producing the multilayer wiring board 11.
Fig. 4B illustrates a step subsequent to Fig. 4A, describing one example of a method for producing the multilayer wiring board 11.
Fig. 4C illustrates a step subsequent to Fig. 4B, describing one example of a method for producing the multilayer wiring board 11.
Fig. 4D illustrates a step subsequent to Fig. 4C, describing one example of a method for producing the multilayer wiring board 11.
Fig. 5A illustrates a step subsequent to Fig. 4D, describing one example of a method for producing the multilayer wiring board 11.
Fig. 5B illustrates a step subsequent to Fig. 5A, describing one example of a method for producing the multilayer wiring board 11.
Fig. 5C illustrates a step subsequent to Fig. 5B, describing one example of a method for producing the multilayer wiring board 11.
Fig. 6A illustrates a step subsequent to Fig. 5C, describing one example of a method for producing the multilayer wiring board 11.
Fig. 6B illustrates a step subsequent to Fig. 6A, describing one example of a method for producing the multilayer wiring board 11.
Fig. 6C illustrates a step subsequent to Fig. 6B, describing one example of a method for producing the multilayer wiring board 11.
Fig. 7A is a schematic sectional view describing, with respect to the first embodiment, the state prior to compressing a via paste 28 filled in a through-hole in a resin sheet 25.
Fig. 7B is a schematic sectional view describing, with respect to the first embodiment, the state subsequent to compressing the via paste 28 filled in the through-hole in the resin sheet 25.
Fig. 8 is a graph showing resistance values (1 via/mΩ) relative to Cu/Sn weight ratios, of via-hole conductors obtained in the Examples.
Fig. 9 is a graph showing a comparison of resistance values, between: via-hole conductors obtained from conventionally-known conductive pastes described in Patent Literature 4; and the via-hole conductor according to the present invention.
Fig. 10 is a schematic sectional view describing a vertical section of a conventional via conductor.
Fig. 11A is a scanning electron microscope (SEM) image at 3000-times magnification, of a vertical section of a via conductor in a multilayer wiring board, obtained in one of the Examples.
Fig. 11B is a tracing of Fig. 11A.
Fig. 12A is a scanning electron microscope (SEM) image at 6000-times magnification, of a vertical section of a via conductor in a multilayer wiring board, obtained in one of the Examples.
Fig. 12B is a tracing of Fig. 12A.
Fig. 13 is a scanning electron microscope (SEM) image at 800-times magnification, of a vertical section of a via conductor in a multilayer wiring board, with plane-to-plane contact portions formed in the via conductor.
Fig. 14 is a scanning electron microscope (SEM) image at 800-times magnification, of a vertical section of a via conductor in a multilayer wiring board, without any plane-to-plane contact portion formed in the via conductor.

### [Description of Embodiment]

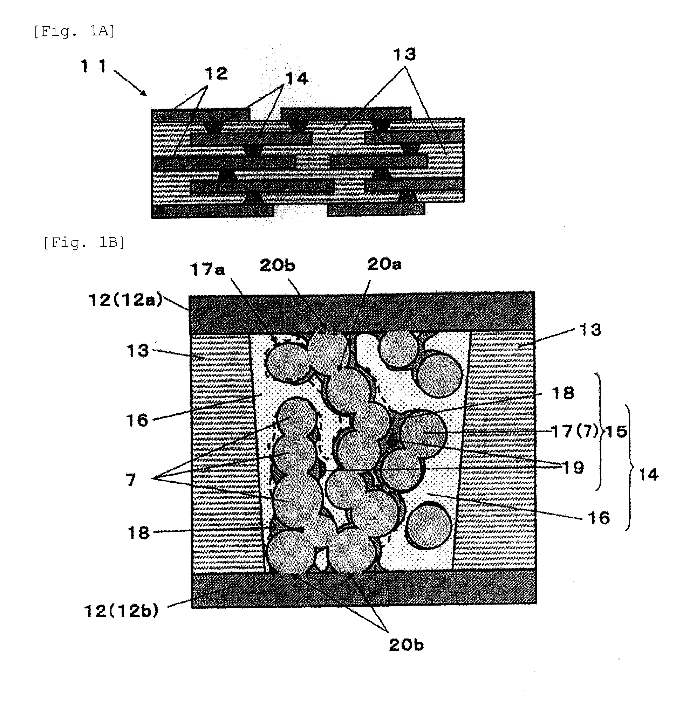

Fig. 1A is a schematic sectional view of a multilayer wiring board 11 of an embodiment according to the present invention. Also, Fig. 1B is an enlarged schematic view showing the vicinity of a via-hole conductor 14 in the multilayer wiring board of Fig. 1A.

As illustrated in Fig. 1A, in a multilayer wiring board 11, copper wirings 12 formed of copper foil are electrically connected to one another by via-hole conductors 14 serving as interlayer connections. The copper wirings 12 are formed three-dimensionally on insulating resin layers 13, and the via hole conductors 14 penetrate through the insulating resin layers 13.

Fig. 1B is an enlarged schematic sectional view showing the vicinity of the via-hole conductor 14. In Fig. 1B, Ref. No. 12 (12a, 12b) denotes the copper wirings, Ref. No. 13 denotes the insulating resin layer, and Ref. No. 14 denotes the via-hole conductor. The via-hole conductor 14 comprises a metal portion 15 and a resin portion 16. The metal portion 15 comprises: first metal regions 17 formed from Cu particles 7; second metal regions 18 mainly composed of at least one metal selected from the group consisting of tin, a tin-copper alloy, and a tin-copper intermetallic compound; and third metal regions 19 mainly composed of Bi. At least a part of the Cu particles 7 forms links 17a thereof, by being in contact with and thus linked to one another via plane-to-plane contact portions 20a where the copper particles 7 directly come into plane-to-plane contact with one another. Also, the links 17a are in contact with and thus linked to the upper copper wiring 12a and/or the lower copper wiring 12b via plane-to-plane contact portions 20b where the links 17a come into plane-to-plane contact with the copper wirings 12. As such, low-resistance connection is achieved at the interface between the link 17a and the copper wiring 12. Also, the plane-to-plane contact portion(s) 20b where the link 17a is in plane-to-plane contact with the upper copper wiring 12a and/or the lower copper wiring 12b, is covered and strengthened with at least a part of the second metal region 18 mainly composed of at least one selected from the group consisting of tin, a tin-copper alloy, and a tin-copper intermetallic compound which are harder than the copper particles, thereby enhancing reliability of electrical connection.

The average particle size of the Cu particles 7 is preferably 0.1 to 20 µm and further preferably 1 to 10 µm. When the average particle size of the Cu particles 7 is too small, there tends to be higher conductive resistance in the via-hole conductor 14 due to increased contact points among the particles therein. Also, particles of the above size tend to be costly. In contrast, when the average particle size of the Cu particles 7 is too large, there tends to be difficulty in increasing the filling rate when forming the via-hole conductors 14 with a small diameter, such as 100 to 150 µmØ.

Purity of the Cu particles 7 is preferably 90 mass% or higher and further preferably 99 mass% or higher. The higher the purity, the softer the Cu particles 7 become. Thus, in a pressurization step that will be described later, the Cu particles 7 are easily pressed against one another, thereby ensuring increased area of contact among the Cu particles due to the Cu particles easily deforming when coming into contact with one another. Higher purity is also preferable in terms of enabling lower resistance of the Cu particle.

Herein, plane-to-plane contact between the copper particles, is not a state where the copper particles are in contact with each other to the extent of merely touching each other, but is a state where the adjacent copper particles are in contact with each other at their respective surfaces due to being pressurized and compressed and thus plastically deformed, resulting in increased contact therebetween. As such, by the copper particles becoming plastically deformed and thus adhered to each other, the plane-to-plane contact portion therebetween are maintained, even after release of compression created during pressurization.

Also, plane-to-plane contact between the copper wiring and the link, is not a state where the copper wiring and the copper particle are in contact with each other to the extent of merely touching each other, but is a state where the copper wiring and the copper particle are in contact with each other at their respective surfaces due to being pressurized and compressed and thus plastically deformed, resulting in increased contact therebetween.

Note that the average particle size of the Cu particles, and also, the plane-to-plane contact portions 20a where the Cu particles come into plane-to-plane contact with one another, are identified and measured by observing a sample with use of a scanning electron microscope (SEM). The sample is created by embedding a formed multilayer wiring board in resin and then polishing a vertical section of the via-hole conductor 14. Microfabrication means such as focused ion beam may also be used as necessary.

The Cu particles 7 come into plane-to-plane contact with one another to form the links 17a, thereby forming low-resistance conductive paths between the copper wiring 12a and the copper wiring 12b. Also, the link 17a come into plane-to-plane contact with the copper wiring 12a and/or the copper wiring 12b, thereby enabling reduced connection resistance between itself and the copper wiring 12a and/or the copper wiring 12b.

Also, in the via-hole conductor 14, it is preferable that the links 17a with low resistance are formed to have a complicated network, by allowing the Cu particles to be in random contact with one another as illustrated in Fig. 1 (B), rather than in orderly arrangement. Formation of the above network by the links 17a enables a more reliable electrical connection. It is also preferable that the Cu particles 7 are in plane-to-plane contact with one another at random positions. By allowing the Cu particles 7 to be in plane-to-plane contact with one another at random positions, the resulting deformation of the particles enables dispersion of stress caused within the via-hole conductor 14 at times of exposure to heat, as well as dispersion of external force that is applied from the outside.

The proportion of the Cu particles 7 included in the via-hole conductor 14 is preferably 30 to 90 mass% and further preferably 40 to 70 mass%. When the proportion of the Cu particles 7 is too small, the links 17a formed of the Cu particles 7 in plane-to-plane contact with one another, are prone to become less reliable as conductive paths to provide electrical connection; and when too large, the resistance value is prone to fluctuate during reliability tests.

As illustrated in Fig. 1B, at least a part of the second metal region 18 mainly composed of at least one metal selected from the group consisting of tin, a tin-copper alloy, and a tin-copper intermetallic compound, is formed on the surface of the first metal region 17, and extends astride the plane-to-plane contact portion 20b where the first copper wiring 12a and the copper particle 7, or where the second copper wiring 12b and the copper particle 7, are in plane-to-plane contact with each other. Also, at least a part of the second metal region 18 extends astride the plane-to-plane contact portion 20a where the copper particles 7 are in plane-to-plane contact with each other. Tin, a tin-copper alloy, and a tin-copper intermetallic compound, at least one of which mainly composes the second metal region, are harder than the copper particles. Therefore, the plane-to-plane contact portion 20a or 20b covered with the second metal region 18 is strengthened, and reliability of electrical connection is enhanced.

The second metal regions 18 are mainly composed of at least one metal selected from the group consisting of tin, a tin-copper alloy, and a tin-copper intermetallic compound. Specifically, for example, they are mainly composed of a simple substance of Sn, Cu₆Sn₅, Cu₃Sn, or the like. Also, for the remainder, other metals such as Bi and Cu may be included to the extent of not ruining the effect of the present invention, that is, specifically in the range of, for example, 10 mass% or less.

Also, as illustrated in Fig. 1B, in the metal portion 15, the third metal regions 19 mainly composed of Bi are preferably present in a manner such that they are not in contact with the first metal regions 17, but are in contact with the second metal regions 18. In the via-hole conductor 14, the third metal regions 19 not in contact with the first metal regions 17 do not reduce conductivity of the first metal regions 17.

The third metal regions 19 are mainly composed of Bi. Also, for the remainder, an alloy, intermetallic compound, or the like, of Bi and Sn, may be included to the extent of not ruining the effect of the present invention, that is, specifically in the range of, for example, 20 mass% or less.

Note that since the second metal regions 18 and the third metal regions 19 are in contact with one another, they normally include both Bi and Sn. In this case, the second metal regions 18 have a higher Sn concentration than the third metal regions 19, while the third metal regions 19 have a higher Bi concentration than the second metal regions 18. In addition, it is preferred that the interface between the second metal region 18 and the third metal region 19 is not definite than being definite. When the interface is not definite, it is possible to prevent stress from concentrating at the interface even under heating conditions for thermal shock tests or the like.

The metal portion 15 included in the via-hole conductor 14 as above comprises: the first metal regions 17 composed of the copper particles 7; the second metal regions 18 mainly composed of at least one metal selected from the group consisting of tin, a tin-copper alloy, and a tin-copper intermetallic compound; and the third metal regions 19 mainly composed of bismuth. Note that the weight ratio between Cu and Sn represented by Cu/Sn in the metal portion 15, is preferably in the range of 1.59 to 21.43. The significance of this Cu/Sn ratio will be described later.

On the other hand, the resin portion 16 included in the via-hole conductor 14 is made of cured material of curable resin. The curable resin is not particularly limited, but specifically, for example, a cured epoxy resin is particularly preferred in terms of excellent heat resistance and lower linear expansion coefficient.

The proportion by volume of the resin portion 16 in the via-hole conductor 14 is preferably 0.1 to 50 vol%, and further preferably 0.5 to 40 vol%. When the proportion by volume of the resin portion 16 is too large, resistance tends to increase, and when too small, preparation of a conductive paste tends to be difficult.

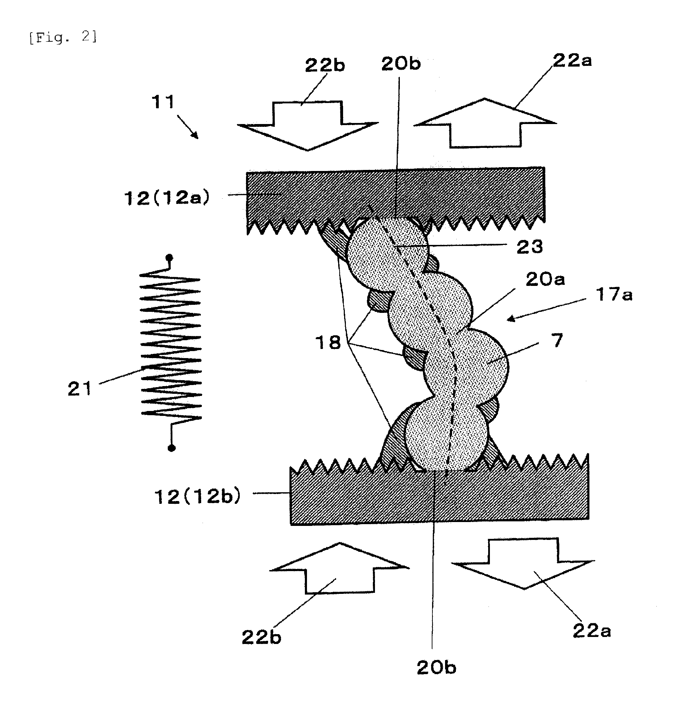

Next, the effect of the via-hole conductors 14 in the multilayer wiring board 11 will be schematically described with reference to Fig. 2.

Fig. 2 is an explanatory drawing for providing a description with focus on the conductive path 23 formed by one of the links 17a each formed by the Cu particles 7 being in contact with one another. Also, for convenience, the resin portion 16, etc. are not illustrated. Furthermore, "21" denotes a virtual spring illustrated for convenience in describing the effect of the via-hole conductor 14.

As illustrated in Fig. 2, the link 17a, which is formed by the Cu particles randomly coming into plane-to-plane contact with one another, comes into plane-to-plane contact with the copper wiring 12a and the copper wiring 12b; and thus becomes the conductive path 23 for creating an electrical interlayer connection therebetween. Usually, as illustrated in Fig. 2, the respective surfaces of the copper wiring 12a and the copper wiring 12b are roughened so that projections and recesses are formed thereon. The reason for this surface roughening is, for example, to improve adhesion of the copper wiring 12a and of the copper wiring 12b to the insulating resin layer 13 and to the resin portion 16 in the via-hole conductor 14 which are illustrated in Fig. 1. Here, the plane-to-plane contact portions 20b are formed by the link 17a wedging, while deforming, into the roughened surfaces of the copper wiring 12a and the copper wiring 12b. Note that at the plane-to-plane contact portion 20a where the Cu particles are in contact with each other, the second metal region 18 is preferably formed in a manner such that it covers around, and extends astride, the plane-to-plane contact portion 20a. The second metal region 18 is also preferably formed in a manner such that it extends astride at least a part of the respective plane-to-plane contact portions 20b where the copper wiring 12a and the link 17a, and where the copper wiring 12b and the link 17a, are in plane-to-plane contact.
Note that the copper wiring 12a and the copper wiring 12b adhere better to the resin portion 16, due to the roughened surfaces thereof. Also, it would be useful to reduce the surface roughness (e.g., Ra, Rz, etc.) at the respective interfaces between the copper wiring 12a and the link 17a in plane-to-plane contact, and between the copper wiring 12b and the link 17a in plane-to-plane contact, than at the respective interfaces between the copper wiring 12a and the resin portion 16 in contact, and between the copper wiring 12b and the resin portion 16 in contact. This is due to the roughened surfaces of the copper wirings 12a and 12b, and the copper particles, coming into plane-to-plane contact with one another as they deform; and these deformations of the copper wirings 12a and 12b mean that there are changes in their surface roughnesses. As such, surface roughnesses of the copper wirings 12a and 12b would change (e.g., the surface becoming physically deformed after pressurization; valleys of recesses and tips of projections becoming smaller; or the like) at the respective interfaces between the copper wiring 12a and the Cu particle, and between the copper wiring 12b and the Cu particle, thereby enabling reduction in the respective connection resistances between the copper wiring 12a and the Cu particle, and between the copper wiring 12b and the Cu particle, and thus enabling enhancement in plane-to-plane contact therebetween.

When internal stress occurs inside the multilayer wiring board 11, force, which is outwardly directed as indicated by arrows 22a, is applied inside the multilayer wiring board 11. Such internal stress occurs, for example, at the time of solder reflow or thermal shock tests, due to the differing thermal expansion coefficients among materials which compose the individual components.

Such outwardly-directed force is reduced by factors such as: deformation of the highly flexible Cu particles 7 themselves; elastic deformation of the link 17a formed by the Cu particles 7 coming into contact with one another; or slight shift in the contact positions among the Cu particles 7. At this time, the second metal regions 18 have a hardness that is greater than that of the Cu particles 7, and thus tend to resist deformation of the link 17a, particularly at the plane-to-plane contact portions 20. Therefore, in the case where the link 17a tends to keep on deforming without limitation, it does not deform to the point of the plane-to-plane contact portion 20 between the Cu particles 7 being divided, since the second metal region 18 regulates the deformation to a certain extent. With respect to the above, in the case where the link 17a formed by the Cu particles 7 being in contact with one another is likened to a spring, when a certain amount of force is applied to the link 17a, the link 17a keeps on deforming to a certain extent as if the spring is stretched; but when the deformation of the link 17a is likely to become greater, it is regulated by the hard second metal regions 18. Asimilar effect as above is also achieved when force, which is directed inwardly as indicated by arrows 22b, is applied to the multilayer wiring board 11. Thus, it is possible to ensure reliability of electrical connection, due to the link 17a acting as if it was the spring 21 and enabling regulation of deformation of the link 17a against forces in any direction, whether external or internal.

Next, to describe an exemplary method for producing the aforementioned multilayer wiring board 11, each step for the production will be described in detail with reference to the drawings.

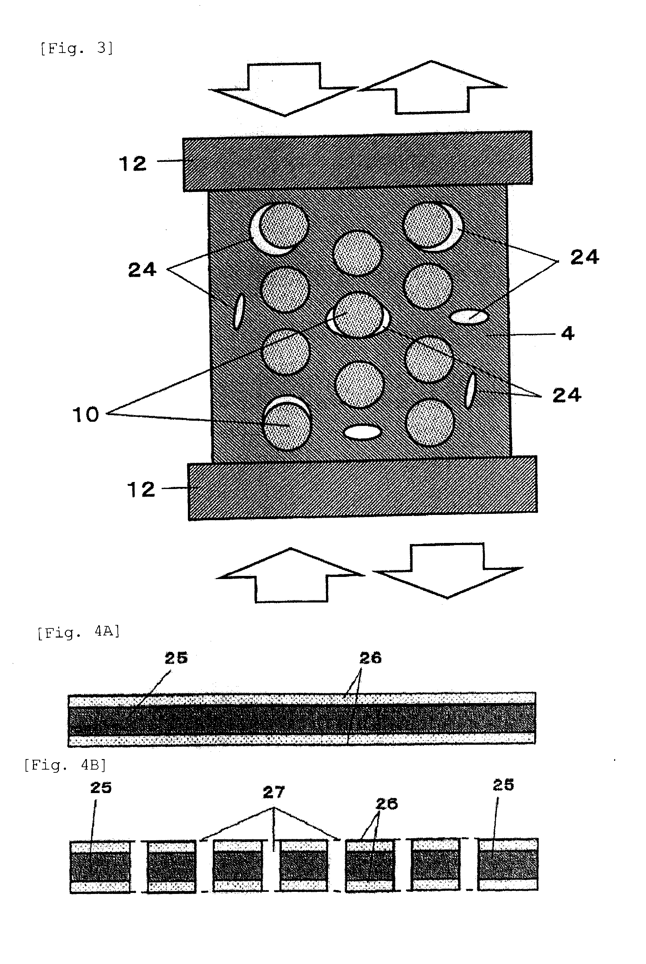

In the production method of the present embodiment, first, as illustrated in Fig. 4A, a protective film 26 is attached to both surfaces of a resin sheet 25. The resin sheet 25 may be an insulating material conventionally used in producing wiring boards, examples thereof including, but not particularly limited to: a resin sheet which is a laminate made of a heat-resistant resin sheet with an uncured resin layer laminated on both surfaces thereof (hereinafter referred to as a heat-resistant resin sheet including uncured layers); a heat-resistant thermoplastic resin sheet; and an uncured or semi-cured (B-stage) prepreg. In the present embodiment, a prepreg as that later described as the resin sheet 25, is used.

Preferably used as the prepreg, is an uncured or semi-cured (B-stage) prepreg that is obtained by impregnating a fiber base material with a resin varnish, followed by drying. The fiber base material may be a woven or non-woven fabric. Specific examples thereof include: glass fiber fabrics such as glass cloth, glass paper, and glass mat; kraft paper; linter sheet; natural fiber fabric; and organic fiber fabric containing aramid fibers. An example of a resin component contained in the resin varnish is an epoxy resin. Inorganic fillers, etc. may further be contained in the resin varnish.

The protective film may be any resin film. Specific examples thereof include resin films of PET (polyethylene terephthalate), PEN (polyethylene naphthalate), and the like. The thickness of the resin film is preferably 0.5 to 50 µm and further preferably 1 to 30 µm. In the case of the above thickness, it is possible to reveal protrusions made from a via paste and of a sufficient height, by removing the protective films. This will be described later.

An example of a method for attaching the protective films 26 to the resin sheet 25, is a method in which the films are directly attached to the sheet with use of tackiness of the resin sheet 25 surface.

Next, as illustrated in Fig. 4B, through-holes 27 are created by perforating the resin sheet 25 with the protective films 26 disposed thereon, starting from the outside of either one of the protective films 26. For the perforation, various methods such as drilling holes, etc. can be used, in addition to a non-contact processing method using a carbon dioxide gas laser, a YAG laser, or the like. The through-holes can have a diameter of 10 to 500 µm, or even about 50 to 300 µm.

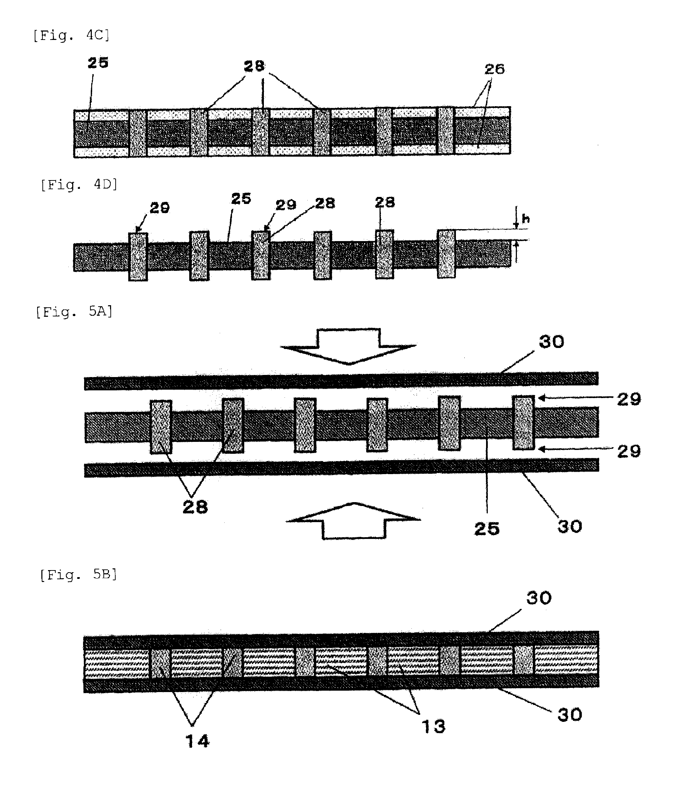

Next, as illustrated in Fig. 4C, the through-holes 27 are fully filled with via paste 28. The via paste 28 contains Cu particles, Sn-Bi solder particles containing Sn and Bi, and a curable resin component such as an epoxy resin.

The average particle size of the Cu particles is preferably in the range of 0.1 to 20 µm, and further preferably 1 to 10 µm. In the case where the average particle size of the Cu particles is too small, it is difficult for the through-holes 27 to be highly filled, and it also tends to be costly. On the other hand, in the case where the average particle size of the Cu particles is too large, filling tends to be difficult when forming via-hole conductors with a smaller diameter.

Also, the Cu particles are not particularly limited to any particle form, and may specifically be, for example, spherical, flat, polygonal, scale-like, flake-like, in a form with surface projections, or the like. Furthermore, the particles may be primary particles, or may be secondary particles.

The Sn-Bi solder particles are not particularly limited, as long as they are solder particles containing Sn and Bi. The eutectic temperature (melting point) of the Sn-Bi solder particles can be changed to about 138°C to 232°C, by changing the proportions of the components therein or by adding various elements thereto. Moreover, the Sn-Bi solder particles may be improved in wettability, flowability, etc., by having indium (In), silver (Ag), zinc (Zn), or the like added thereto. Particularly preferred are Sn-58Bi solder and the like, being environmentally-friendly lead-free solders with a low eutectic point of 138°C.

The average particle size of the Sn-Bi solder particles is preferably in the range of 0.1 to 20 µm, and further preferably 2 to 15 µm. In the case where the average particle size of the Sn-Bi solder particles is too small, melting of the particles tends to be difficult, due to increased specific surface area which results in increased proportion of an oxide film on the particle surface. On the other hand, in the case where the average particle size of the Sn-Bi solder particles is too large, the ability of the particles to fill the via holes tends to become poor.

Specific examples of the epoxy resin being the preferred curable resin component, include glycidyl ether epoxy resin, alycyclic epoxy resin, glycidyl amine epoxy resin, glycidyl ester epoxy resin, and other modified epoxy resins.

Also, a curing agent may be blended with the epoxy resin in a combination. The curing agent is not limited to any particular kind, but is particularly preferably a curing agent which contains an amine compound having at least one or more hydroxyl groups in its molecule. The above curing agent is preferable, in terms of working as a curing catalyst for the epoxy resin, and also, of having an effect of producing lower contact resistance at the time the particles join together, by reducing the oxide film that is on the surface of the Cu particles and on the surface of the Sn-Bi solder particles. Particularly preferred is the amine compound with a boiling point higher than the melting point of the Sn-Bi solder particles, in terms of being highly effective, particularly in obtaining lower contact resistance at the time the particles join together.

The via paste is prepared by mixing the Cu particles, the Sn-Bi solder particles containing Sn and Bi, and the curable resin component such as the epoxy resin. Specifically, the via paste is prepared by, for example, adding the Cu particles and the Sn-Bi solder particles to a resin varnish which contains an epoxy resin, a curing agent, and a predetermined amount of an organic solvent, and then mixing the resultant with a planetary mixer or the like.

The proportion of the curable resin component to be blended, relative to the total amount of the curable resin component and the metal component including the Cu particles and Sn-Bi solder particles, is preferably in the range of 0.3 to 30 mass%, and further preferably 3 to 20 mass%, in terms of achieving lower resistance and of ensuring sufficient workability.

Also, with respect to the content of the Cu particles in the metal component, it is preferable that they are contained therein such that the weight ratio of Cu/Sn between Cu and Sn is in the range of 1.59 to 21.43. The reason for the above will be described later. Therefore, for example, when Sn-58Bi solder particles are used as the Sn-Bi solder particles, the content of the Cu particles relative to the total amount of the Cu particles and the Sn-58Bi solder particles, is preferably 40 to 90 mass%, and further preferably 55.8 to 65.5 mass%

The method for filling the through-holes with the via paste is not particularly limited. Specifically, for example, a method such as screen printing or the like is used. Note that in the production method of the present embodiment, when filling the through-holes with the via paste, it is necessary that the amount filled is to the extent that the via paste flows out from the through-holes 27 formed in the resin sheet 25, so that when the protective films 26 are removed after the filling step, the via paste 28 partially protrudes from the through-holes 27, thereby allowing protrusions to be revealed.

Next, as illustrated in Fig. 4D, the protective films 26 are removed from the surfaces of the resin sheet 25, thereby allowing the via paste 28 to partially protrude from the through-holes 27, as protrusions 29. Height "h" of the protrusions 29 depends on the thickness of the protective films, and is, for example, preferably 0.5 to 50 µm and further preferably, 1 to 30 µm. When the height of the protrusions 29 is too high, it is not preferable, since the paste may possibly overflow and spread around the through-holes 27 on the surfaces of the resin sheet 25 during a compression-bonding step that will be described later, thereby causing loss of surface smoothness. When too low, during the compression-bonding step that will be described later, pressure does not tend to be sufficiently exerted to the via paste filled in the through-holes.

Next, as illustrated in Fig. 5A, copper foils 30 are disposed on the resin sheet 25 and then pressed in directions indicated by arrows. Thus, the resin sheet 25 integrated with the copper foils 30 as illustrated in Fig. 5B results in formation of an insulating resin layer 13. In this case, at the beginning of the pressing, force is applied to the protrusions 29 with the copper foil 30 disposed thereon. Therefore, the via paste 28 filled in the through-holes 27 is compressed under high pressure. Thus, space among the Cu particles contained in the via paste 28 are narrowed, and the Cu particles deform, causing them to come into plane-to-plane contact with one another. At the same time, the Cu particles contained in the via paste 28 deform, and thus wedge into and come into plane-to-plane contact with the copper foils 30.

Pressing conditions are not particularly limited, but the mold temperature is preferably set to be in the range from room temperature (20°C) to a temperature lower than the eutectic temperature (melting point) of the Sn-Bi solder particles. Also, in this pressing step, a hot press machine may be used to promote curing of the uncured resin in the resin sheet 25, with the hot press machine heated to a temperature necessary to promote the curing.

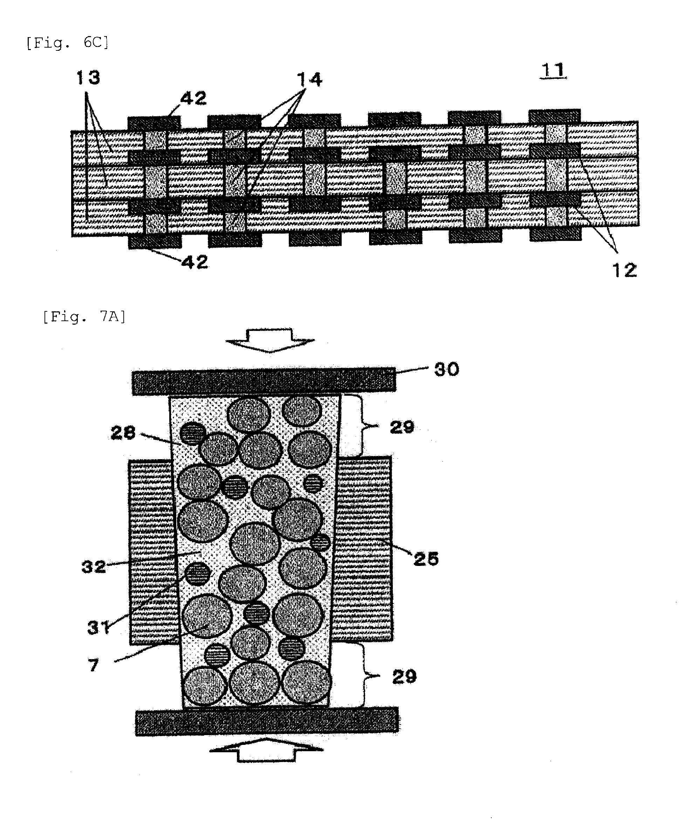

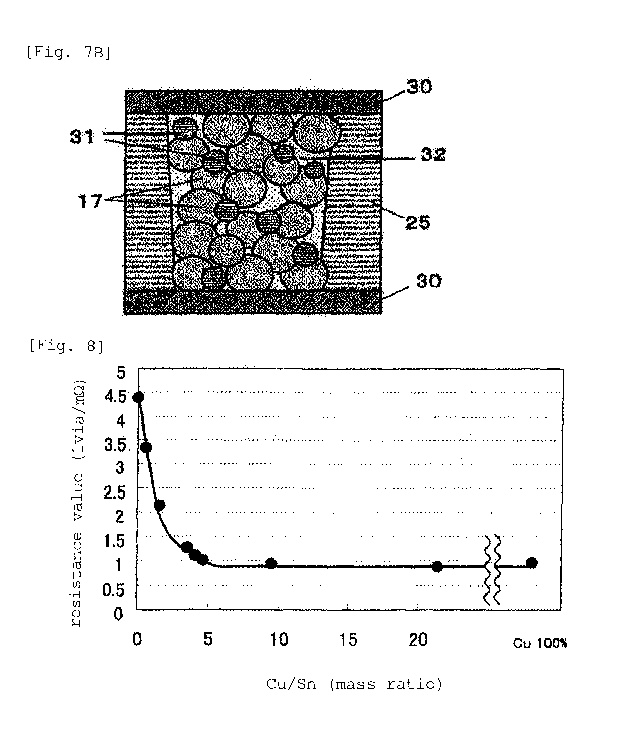

The manner in which the via paste 28 having the protrusions 29 is compressed, will now be described in detail with reference to Figs. 7A and 7B.

Fig. 7A is schematic sectional view of the vicinity of the through-hole 27 in the resin sheet 25 which is filled with the via paste 28, before the compression. Fig. 7B is schematic sectional view of the vicinity of the through-hole 27 in the resin sheet 25 which is filled with the via paste 28, after the compression.

As illustrated in Fig. 7A, the protrusions 29 protruding from the through-hole 27 created in the resin sheet 25 are pressed, with the copper foils 30 disposed on the protrusions 29. This causes the via paste 28 filled in the through-hole 27 to be compressed, as illustrated in Fig. 7B. By pressurization caused during the compression, the curable resin component 32 may be partially forced out, onto the surfaces of the resin sheet 25. As a result, the Cu particles 7 and the Sn-Bi solder particles 31 filled in the through-hole 27 increase in density.

The Cu particles which are made highly dense as above, come into contact with one another. During the compression, first, the Cu particles 7 come into point-to-point contact with one another, and then, they are pressed against one another as pressure increases. This causes the particles to deform and to come into plane-to-plane contact with one another. At the same time, the Cu particles 7, which are pressed against one another with the increase in pressure, also deform such that they wedge into and come into plane-to-plane contact with the copper foils 30. As such, the Cu particles 7 coming into plane-to-plane contact with one another, and the Cu particles 7 and the copper foils 30 also coming into plane-to-plane contact, cause formation of the links 17a which serve to electrically connect, with low resistance, the upper wiring and the lower wiring.

The via paste 28 is pressurized and compressed, preferably by compression bonding the copper foils 30 onto the resin sheet 25, and then applying a predetermined amount of pressure to the protrusions 29 of the via paste 28, the protrusions 29 having the copper foil 30 disposed thereon. This allows the copper particles 7 to come into plane-to-plane contact with one another, thereby forming first metal regions 17 including the links 17a of the copper particles 7. To make the copper particles 7 come into plane-to-plane contact, they are preferably pressurized and compressed until they are plastically deformed against one another. Also, in this compression bonding step, it is effective to perform heating (or start heating) as necessary. This is because it is effective to carry out a heating step subsequent to the compression bonding step.

Further, it is effective to partially melt the Sn-Bi solder particles 31 by heating them at a predetermined temperature, while maintaining the above compression-bonded state. By performing heating while maintaining the compression-bonded state and thus melting the Sn-Bi solder particles 31, it is possible to prevent molten Sn-Bi solder or the like, or resin or the like, from entering the plane-to-plane contact portion between the copper particles 7. Thus, it is effective to include a heating step as a part in the compression bonding step. Also, by starting the heating in the compression bonding step, productivity can be increased since the total time of the compression bonding step and the heating step can be shortened.

Also, second metal regions mainly composed of any one or more of tin, a tin-copper alloy, and a tin-copper intermetallic compound, are each preferably formed on the surface of the link of the copper particles, the surface excluding the area of plane-to-plane contact portion, in the manner of: heating the compressed via paste while maintaining the compression, so as to partially melt the Sn-Bi solder particles at a temperature in the range from the eutectic temperature of the Sn-Bi solder particles, to the eutectic temperature plus 10°C; and then, further heating the resultant at a temperature in the range from the eutectic temperature plus 20°C, to 300°C. It is effective to designate a step comprising the above compression bonding and heating, as one step. By this one step in which the compression bonding, the heating, and the metal region formation are performed in succession, it is possible to stabilize the formation reaction of each of the above metal regions, and to stabilize the structure of the vias themselves.

The links 17a are formed by compression, and then, the via paste 28 is further heated in a gradual manner until reaching a temperature equal to or higher than the eutectic temperature of the Sn-Bi solder particles 31. By the heating, the Sn-Bi solder particles 31 partially becomes molten in an amount equal to that in which the composition becomes molten at that reached temperature. Also, the second metal regions 18 mainly composed of tin, a tin-copper alloy, and/or a tin-copper intermetallic compound are each formed on the surface of, or around, the Cu particles 7 and the links 17a. In this case, the plane-to-plane contact portion 20, where the Cu particles 7 are in plane-to-plane contact with each other, is preferably covered by the second metal region 18 in a manner such that it extends astride the portion 20. The second metal regions 18 mainly composed of a layer of a Sn-Cu compound including Cu₆Sn₅ or Cu₃Sn (intermetallic compound), or of a tin-copper alloy, are formed from the Cu particles 7 and the molten Sn-Bi solder particles 31 coming into contact with one another and causing the Cu in the Cu particles 7 and the Sn in the Sn-Bi solder particles 31 to react with one another. On the other hand, third metal regions 18 mainly composed of Bi are formed from the molten state of the Sn-Bi solder particles 31 that continue to be in a molten state while Sn is being compensated from the Sn phase in the solder particles 31 and the Bi is remaining in the solder particles 31 to be deposited. This results in obtaining of the via-hole conductors 14 having the structure as illustrated in Fig. 1B.

More specifically, the Cu particles 7, which are made highly dense as above, come into contact with one another by compression. During the compression, first, the Cu particles 7 come into point-to-point contact with one another, and then, they are pressed against one another as pressure increases. This causes the particles to deform and to come into plane-to-plane contact with one another. The Cu particles 7 coming into plane-to-plane contact with one another as described above, causes formation of the links 17a which serve to electrically connect, with low resistance, the upper wiring and the lower wiring. Also, it is possible to form the links 17a with the Cu particles 17 in direct contact with one another, due to the plane-to-plane contact portions not being covered with the Sn-Bi solder particles 31. As a result, the conductive paths formed can be reduced in electrical resistance. Subsequently, heating is performed while in the above state, and the Sn-Bi solder particles 31 start to partially melt when temperature reaches the eutectic temperature thereof or higher. The composition of the solder that melts is determined by temperature, and the Sn that does not easily melt at the temperature during the heating remains as solid phase substance. Also, when the Cu particles 7 come into contact with the molten Sn-Bi solder, and the surface of the particles gets wet with the molten solder, interdiffusion between the Cu and the Sn progresses at the interface of the wet part, resulting in formation of the Sn-Cu compound layer, or the like. As above, the second metal regions 18 are produced in a manner such that they each come into contact with the surface of the Cu particles 7, the surface excluding the area of the plane-to-plane contact portion. The second metal region 18 is partially formed in a manner such that it extends astride the plane-to-plane contact portion. As above, in the case where the second metal region 18 partially covers the plane-to-plane contact portion in a manner such that it extends astride that portion, the plane-to-plane contact portions are strengthened and the conductive path becomes highly elastic. Also, further progression in the formation of the Sn-Cu compound layer or the like, or in the interdiffusion, causes the decrease of Sn in the molten solder. This decrease of Sn in the molten solder is compensated by the Sn solid phase, and therefore, the molten state is continued to be maintained. When Sn further decreases and Bi increases with respect to the ratio between Sn and Bi in the Sn-57Bi particles, segregation of Bi begins, and the second metal regions are formed in a manner such that they are deposited as solid-phase substances mainly composed of bismuth.

Well-known solder materials that melt at relatively low temperatures include Sn-Pb solders, Sn-In solders, Sn-Bi solders, etc. Among these materials, In is costly and Pb is highly environmentally unfriendly.
On the other hand, the melting point of Sn-Bi solders is lower than the typical solder reflow temperature used when electronic components are surface mounted. Therefore, in the case where only Sn-Bi solder is simply used for via-hole conductors of a circuit board, there is a possibility of varied via resistance due to the solder in the via-hole conductors remelting at the time of solder reflow. On the other hand, in the case where the via paste of the present embodiment is used, Sn concentration in the Sn-Bi solder particles becomes lower due to Sn therein reacting with the surface of the Cu particles; and at the same time, a Bi phase is produced due to Bi being deposited after the Sn-Bi solder particles undergo heating and cooling. By allowing the Bi phase to be deposited and thus be present as described above, remelting of the solder in the via-hole conductors becomes unlikely, even under solder reflow. As a result, varied resistance is prevented even after solder reflow.

The temperature for heating the via paste 28 after the compression is not particularly limited, as long as it is equal to or higher than the eutectic temperature of the Sn-Bi solder particles 31 and is within a temperature range that does not allow decomposition of the components of the resin sheet 25. Specifically, for example, in the case of using as the Sn-Bi solder particles, the Sn-58Bi solder particles having an eutectic temperature of 139°C, it is preferable that: first, the Sn-58Bi solder particles are heated to a temperature in the range of 139 to 149°C so as to melt a part of the particles; and then, further heated in a gradual manner to a temperature in the range of about 159 to 230°C. Note that by appropriately selecting the temperature at this time, it is possible to cure the curable resin component included in the via paste 28.

In this manner, the via-hole conductors 14 serving as an interlayer connection between the upper wiring and the lower wiring, are formed.

In the present embodiment, the content of the Cu particles in the metal component included in the via paste 28 is preferably such that the weight ratio of Cu/Sn between Cu and Sn is in the range of 1.59 to 21.43 as already mentioned. The reason for the above will be described in the following.

Fig. 3 is a schematic sectional view, showing one example of a via-hole conductor when Cu/Sn is smaller than 1.59.

As illustrated in Fig. 3, when the ratio of Cu/Sn is smaller than 1.59, the proportion of Cu in the via-hole conductor becomes smaller; plane-to-plane contact among the Cu particles 10 becomes difficult; and as a result, the Cu particles 10 tend to be present in an interspersed manner throughout a matrix comprising an intermetallic compound 4. In this case, the via-hole conductor itself also tends to become rigid with low spring-like properties, since the Cu particles 10 are rigidly bound by the hard intermetallic compound 4. Compared to the Cu particles 10, the intermetallc compound 4 such as Cu₆Sn₅ or Cu₃Sn is harder and more difficult to deform. According to what the inventors found out, the Vickers hardness for Cu₆Sn₅ and Cu₃Sn are about 378 Kg/mm² and about 343 Kg/mm², respectively, being remarkably higher than that for Cu which is 117 Kg/mm².

The Cu particles 10 and the intermetallic compound 4 differ in coefficient of thermal expansion. Therefore, during solder reflow, internal stress occurs due to this difference in coefficient of thermal expansion. As a result, voids or cracks 24 are easily created.

Also, voids easily occur when the weight ratio of Cu/Sn is smaller than 1.59. One of the critical factors which causes such occurrence of voids, is formation of Kirkendall voids due to the Kirkendall effect caused by contact and diffusion between Sn and Cu. Kirkendall voids tend to occur at the interface between the surface of the Cu particle and Sn packed in the space between the Cu particles, or between the surface of the Cu particle and an alloy containing Sn.

When the voids or cracks 24 are present at the interface between the copper particle 10 and the intermetallc compound 4 as illustrated in Fig. 3, there is a tendency for the voids or cracks 24 to easily propagate and spread. When Kirkendall voids occur, there is a tendency for such Kirkendall voids to easily propagate and spread as well. Particularly, in the case where the via-hole conductor has a small diameter, the voids or cracks 24 tend to become the cause of cohesive failure of the intermetallic compound 4, and furthermore, of breaking of the via-hole conductor. If such cohesive failure and interfacial failure occur inside the via-hole conductor, electrical resistance of the via portion would increase, and reliability thereof would be affected.

In the following, the case where the ratio of Cu/Sn is 1.59 or more will be schematically described with reference to Figs. 1 (B) and 2.
When the ratio of Cu/Sn is 1.59 or more, the second metal region 18 included in the metal portion 15 physically protects the following, as illustrated in Fig. 1 B: the plane-to-plane contact portions 20a where the Cu particles come into plane-to-plane contact with one another; the plane-to-plane contact portions 20b where the Cu particles and the copper wiring 12 come into plane-to-plane contact with one another; and the surface of the Cu particles. The arrows 22a and 22b illustrated in Fig. 2 indicate outwardly-directed force applied inside the via-hole conductor 14 and internal stress that occurs inside the via-hole conductor 14, respectively. In the case where the outwardly-directed force as indicated by the arrows 22a and the internal stress 22b are applied inside the via-hole conductor 14, force is moderated by deformations of the flexible Cu particles 7. Also, even if cracks occur in the second metal regions 18, electrical characteristics and reliability are not greatly affected, since the conductive paths formed by the links 17a, which are the Cu particles 7 in plane-to-plane contact with one another, are sufficiently secured. Note that deformation of the metal portion 15 as a whole is further suppressed within a certain range, since it is protected by the resin portion 16 in an elastic manner. Therefore, cohesive failure and interfacial failure do not tend to occur easily.

Also, when Cu/Sn is 1.59 or more, it is easier for the second metal region 18 to be formed such that it extends astride the plane-to-plane contact portion 20a and the plane-to-plane contact portion 20b. Moreover, when the Cu/Sn is 1.59 or more, Kirkendall voids tend to easily occur in the second metal region 18, rather than inside the Sn-Bi solder particles packed in the space between the Cu particles, and at the interface between the Sn-Bi solder particle and the Cu particle. However, electrical characteristics and reliability of the via-hole conductor 14 are not easily affected by the Kirkendall voids which occur in the second metal region 18. This is because electrical conduction is sufficiently secured due to contact among the Cu particles.

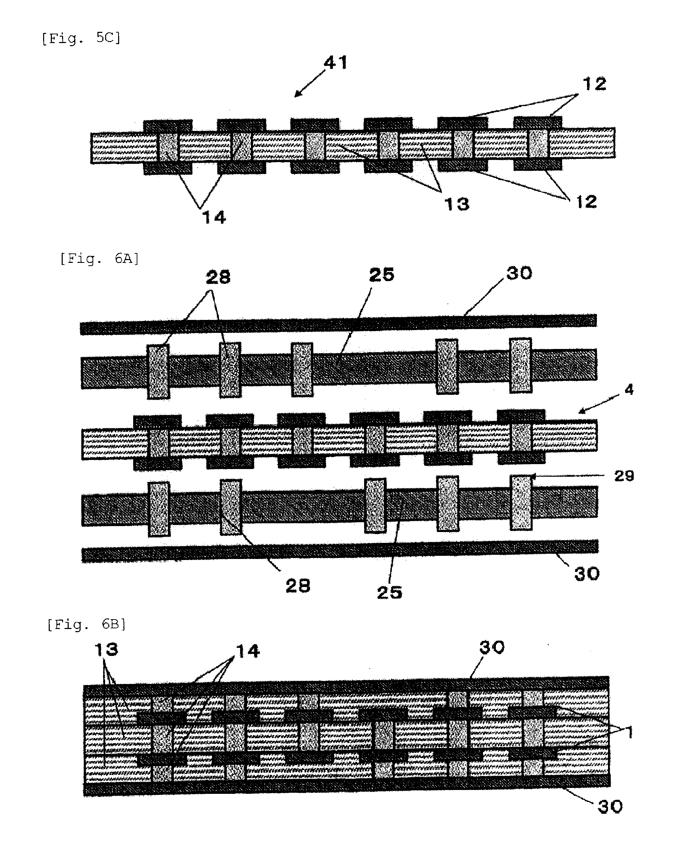

Next, copper wirings 12 are formed as illustrated in Fig. 5C. The copper wirings 12 are each formed by: forming a photoresist film on the surface of the copper foil 30 that is attached to the surface layer; patterning the photoresist film by selective exposure through a photomask; developing the photoresist film; etching the resultant to remove the copper foil in a selective manner, that is, to remove the copper other than the wiring portions; and then, removing the photoresist film. A liquid resist or a dry film may be used to form the photoresist film.

The above step results in obtaining a wiring board 41 having circuits formed on both surfaces thereof, the wiring board including the upper copper wiring 12a and the lower copper wiring 12b that are connected via the via-hole conductors 14. Further, by multilayering the above wiring board 41, a multilayer wiring board 11 in which interlayer connections are created among layers of circuits, as illustrated in Fig. 1 (A), is obtained. The manner in which the wiring board 41 is multilayered, will be described with reference to Fig. 6.

First, as illustrated in Fig. 6A, the resin sheet 25 having the protrusions 29 made of the via paste 28 that is obtained in the same manner as in Fig. 4D, is disposed on both surfaces of the wiring board 41 obtained as described above. Further, a copper foil 30 is disposed on the outer surface of each of the resin sheets 25, thereby forming a stacked structure. Then, the stacked structure is placed into a mold for pressing, followed by pressing and heating under the conditions as described above to obtain a laminate as illustrated in Fig. 6B. Then, new wirings 42 are formed by performing the photo processing as described above. By additionally repeating the above multilayering process, a multilayer wiring board 11 is obtained.

Next, the present invention will be described more specifically by way of Examples. Note that the contents of the Examples are not to be in any way construed as limiting the scope of the present invention.

### [Examples]

First, a description will be given on all of the raw materials used in the present Examples.
- Cu particles: "1100Y" with an average particle size of 5 µm, available from Mitsui Mining & Smelting Co., Ltd.
- Sn-Bi solder particles: Sn42-Bi58, with an average particle size of 3 µm and an eutectic temperature of 138°C, available from Yamaishi Metal Co., Ltd.
- Epoxy resin: "jeR871" available from Japan Epoxy Resin K.K., and a curing agent
- Resin sheet: a 75 µm-thick, 500 mm (height) x 500 mm (width) polyimide film, with a 12.5 µm-thick uncured epoxy resin layer laminated on both surfaces of the film
- Protective film: a 25 µm-thick PET sheet
- Copper foil (thickness: 25 µm)

### (Preparation of via paste)

The Cu particles, the Sn42-Bi58 solder particles, the epoxy resin, and the curing agent were blended at a blend ratio as in Table 1, and then mixed with a planetary mixer, thereby preparing a via paste.

### (Production of Multilayer Wiring Board)

The protective film was attached to both surfaces of the resin sheet. Then, by using a laser from the outer side of the protective films attached thereto, 100 or more perforations having a diameter of 150 µm were created.

Next, the through-holes were fully filled with the prepared via paste. Then, the protective films on the both surfaces were removed, thereby revealing protrusions formed by the via paste partially protruding from the through-holes.

Next, the copper foil was disposed on the both surfaces of the resin sheet, so as to cover the protrusions. Then, a laminate of the copper foils and the resin sheet was placed on the lower mold of a pair of molds for heat pressing, with a release paper placed between the laminate and the mold. Thereafter, the temperature for the heat pressing was increased from a room temperature of 25°C to a maximum temperature of 220 °C in 60 minutes, kept at 220 °C for 60 minutes, and then cooled down to the room temperature in 60 minutes. Note that the pressure for the pressing was 3 MPa. In this manner, a multilayer wiring board was obtained.

### (Evaluation)

### <Resistance Test>

The 100 via-hole conductors formed in the obtained multilayer wiring board were measured for resistance by a four-terminal method. Then, for each of the 100 via-hole conductors, the average of the measured resistances (hereinafter referred to as average resistance) was obtained, and the maximum of the measured resistances (hereinafter referred to as maximum resistance) was obtained. For maximum resistance, values lower than 2 mΩ were evaluated as "A", values equal to 2 to 3 mΩ were evaluated as "B", and values exceeding 3 mΩ were evaluated as "C". It can be said that if maximum resistance is low, the standard deviation 6 of the resistance would also be low.
<Connection Reliability>
The multilayer wiring board measured for initial resistance was subjected to a thermal cycle test of 500 cycles. The via-hole conductors with 10% or lower percent of change from the initial resistance was evaluated as "A", and those with higher than 10% of change from the initial resistance was evaluated as "B".
The results are shown in Table 1. Fig. 8 is a graph on which average resistance values relative to Cu/Sn mass ratios are plotted.

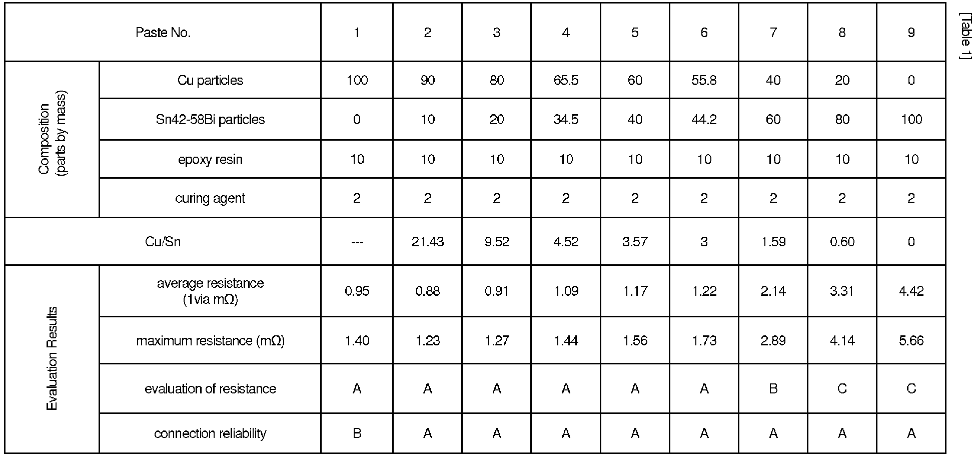

From Table 1 and the graph of Fig. 8, it is evident that resistance rapidly declines from where the weight ratio of Cu/Sn is near 1.59, and then near 3. This is presumed to be due to a larger percentage of plane-to-plane contact among the Cu particles of lower resistance, due to increase in the proportion of the Cu particles. That is, it is presumed to be due to there being hardly any metal, higher in resistance than Cu, present between the adjacent Cu particles. Also, it is presumed that low resistance is obtained by plane-to-plane contact between the Cu particles and the copper foils, without a metal higher in resistance than Cu interposed therebetween.

In other words, the above is presumed to be due to a metal higher in resistance than Cu being interspersed among the Cu particles and being interposed between the Cu particles and the copper foils, in the case where Cu/Sn is smaller than 1.59, which is when resistance rapidly increases.

Also, it is evident from Table 1 that average resistance and maximum resistance become 3 mΩ or lower when the proportion of the Sn42-58Bi particles is 60 mass% or less; and 2 mΩ or lower when 44.2 mass% or less, and thus lowering to an extreme extent.

Also, it is evident that both lower resistance and higher reliability are achieved when the proportion of the Sn42-58Bi particles is in the range of 10 to 60 mass%. If the proportion of the Sn42-58Bi particles is too small, connection reliability would be insufficient, since there would be less of the second metal regions present around the plane-to-plane contact portions where the Cu particles are in contact and around the plane-to-plane contact portions where the Cu particles and the copper foil are in contact. On the other hand, if the proportion of the Sn42-58Bi particles is too high, there would be too much of the second metal regions. This would lessen the plane-to-plane contact portions where the Cu particles are in contact and the plane-to-plane contact portions where the Cu particles and the copper foil are in contact, and as a result, resistance would tend to become higher.

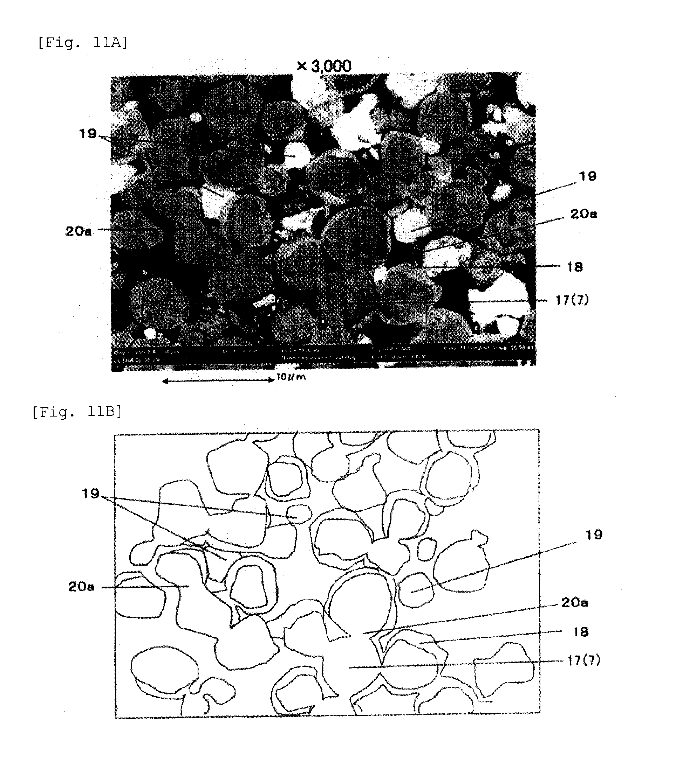

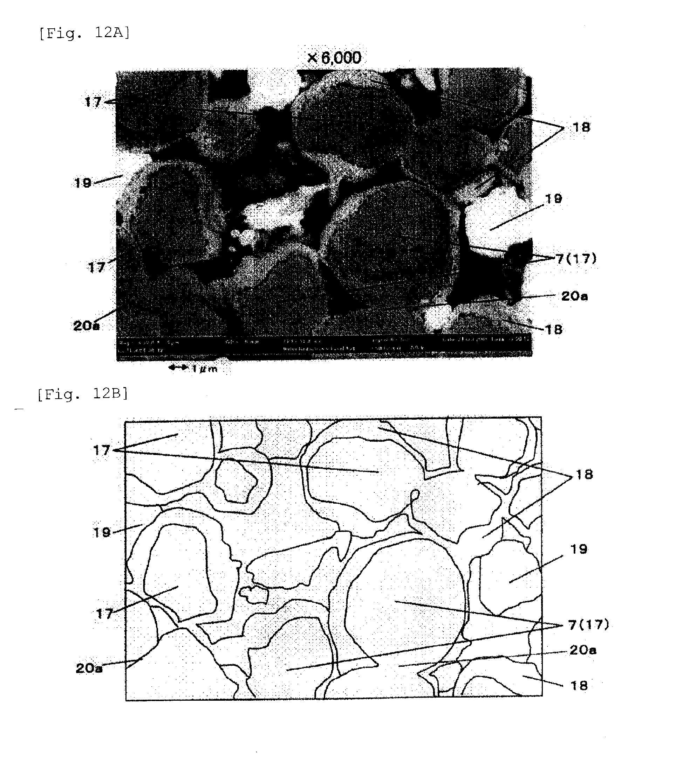

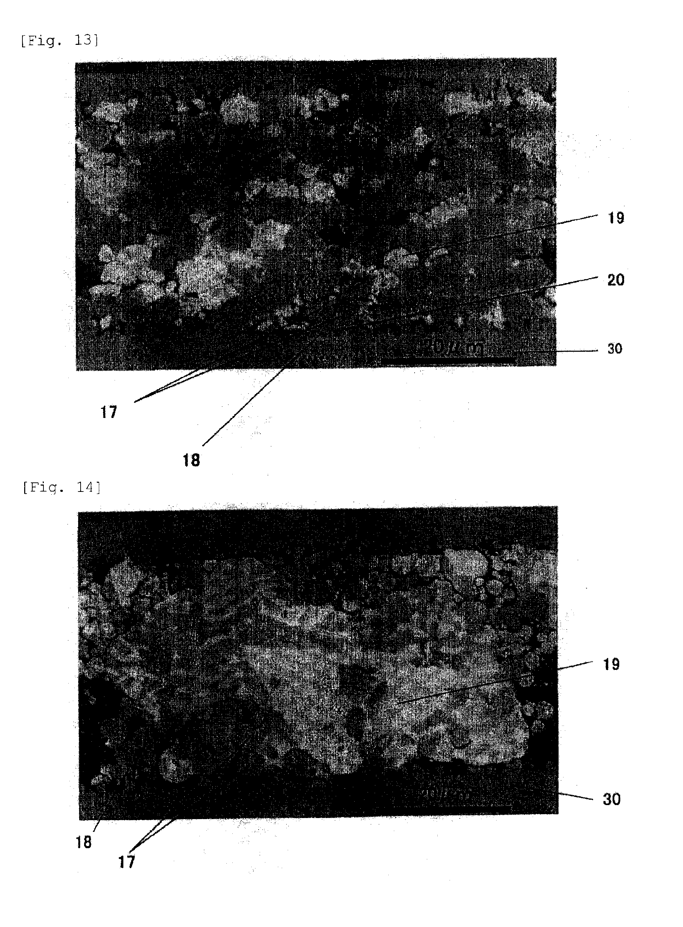

Herein, shown are exemplary images created by a scanning electron microscope (SEM), together with their tracings, of a vertical section of the via-hole conductor in the multilayer wiring board obtained by using Paste No. 5. Figs. 11A and 12A are SEM images at magnifications of 3000 times and 6000 times, respectively. Also, Figs. 11B and 12B are tracings of Figs. 11A and 13A, respectively. Also, Fig. 13 is a SEM image at a magnification of 800 times. Fig. 14 is a SEM image at a magnification of 800 times, of a vertical section of a via-hole conductor in a multilayer wiring board obtained by using Paste No. 8.

It is evident from Figs. 11A and 12A that the via-hole conductor obtained by using Paste No. 5 is highly filled with the Cu particles 7; and the Cu particles 7 come into plane-to-plane contact with one another, thereby forming plane-to-plane contact portions 20a. It is evident from the above, that conductive paths with low resistance are formed. Also, it is evident that, formed on the surfaces of the links each formed by the Cu particles 7 coming into plane-to-plane contact with one another, are the second metal regions 18 mainly composed of tin (Sn), a tin-copper intermetallic compound, or a tin-copper alloy, each of the regions being formed in a manner such that it extends astride the plane-to-plane contact portion 20a. Also, it is evident that the third metal regions 19 mainly composed of Bi which has high resistance, are substantially not in contact with the Cu particles. It is presumed that, with respect to these third metal regions, Bi is deposited at high concentrations due to Sn forming an alloy with Cu (e.g., intermetallic compound) on the surface of the Cu particles 7. Also, in the SEM image of Fig. 13, the circled area shows that the Cu particles 7 plastically deform and come into plane-to-plane contact with the copper foil, at the respective interfaces between the Cu particle 7 and the copper foil.
On the other hand, in the via-hole conductor obtained by using Paste No. 8, there is no plane-to-plane contact among the copper particles or at the interface between the Cu particle and the copper foil. This is as illustrated in Fig. 14. Therefore, since low-resistance conductive paths made of copper are not formed, maximum resistance becomes higher.

### [Comparison with Prior Art]

Next, a description will be given on the results obtained from a comparison made among the resistance of the via-hole conductor for a multilayer wiring board, described above in the Example; and the resistances of different kinds of via-hole conductors according to Patent Literature 4, also described above.

Fig. 9 is a graph showing a comparison of resistance values between a via-hole conductor for a multilayer wiring board, according to the Example; and the different kinds of via-hole conductors for a multilayer wiring board, according to Patent Literature 4.

In Fig. 9, the horizontal axis (X-axis) represents the Bi content in the via-hole conductor, expressed by mass%; and the vertical axis (Y-axis) represents the resistance value of the via-hole conductor, expressed by a relative value ("1" being the relative value of the lowest resistance value).

Line I in Fig. 9 shows the change in the relative resistance values, which are the results of [Table 1] in Example 1.

On the other hand, line II in Fig. 9 shows the change in the relative resistance values in the case of "Sn-2Ag-0.5Cu-20Bi" listed in Table 1 of Patent Literature 4. Also, line III in Fig. 9 shows the change in the relative resistance values in the case of "Sn-2Ag-0.5Cu-15Bi" listed in Table 1 of Patent Literature 4. Also, line IV in Fig. 9 shows the change in the relative resistance values in the case of "Sn-58Bi" listed in Table 1 of Patent Literature 4.
It is evident from Fig. 9 that, in the case of the via-hole conductor as shown by line I, that is, the via-hole conductor for a multilayer wiring board according to the Example, there is almost no increase in resistance of the via-hole conductor, even when the Bi content in the via-hole conductor increases. This is due to the fact that, in the via-hole conductor for a multilayer wiring board according to the Example, the copper particles come directly into plane-to-plane contact with one another, thereby forming the links made from the copper particles; and the links also come into plane-to-plane contact with the wirings, thereby enabling the links to electrically connect therewith. Therefore, there is almost no increase in the resistance value, even when the Bi content increases.
On the other hand, in the case of the via-hole conductors shown by lines II, III, and IV, respectively, that is, the via-hole conductors for a multilayer wiring board listed in Table 1 of Patent Literature 4, it is evident that the resistance of the via-hole conductor rapidly increases, as the Bi content in the via-hole conductor increases. This is presumed to be due to the fact that, in the different kinds of the via-hole conductors according to Patent Literature 4, copper particles are electrically connected to one another with a high-resistance metal component interposed therebeween. This is presumed to be due to "a melted metal component taking part in the connection" as described in paragraph 0015 of Patent Literature 4. That is, it is presumed to be due to the high-resistance metal component between the copper particles becoming thicker, as the bismuth content increases.
As such, in the case of the via-hole conductor for a multilayer wiring board according to the Example, low resistance is maintained, since there is almost no rapid increase in the resistance of the via-hole conductor even when the bismuth content in the via-hole conductor increases. This is due to the copper particles forming the links by coming into contact with one another via the plane-to-plane contact portions; and the links also coming into plane-to-plane contact with the wirings, thereby enabling the links to electrically connect therewith.

### [Industrial Applicability]

According to the present invention, it is possible to further reduce the cost and size, and to further enhance functionality and reliability of multilayer wiring boards for use in, for example, cell phones. Also, in terms of via pastes, proposing a via paste most appropriate for producing a via paste reaction-induced material in via-hole conductors with a smaller diameter, would contribute to size reduction and reliability enhancement of multilayer wiring boards.

### [Explanation of Reference Numerals]

- 1: wiring
- 2: via conductor
- 3: copper-containing powder
- 4: intermetallic compound
- 5, 24: void or crack
- 7: copper particle
- 11: multilayer wiring board
- 12 (12a, 12b): copper wiring
- 13: insulating resin layer
- 15: metal portion
- 16: resin portion
- 17: first metal region
- 17a: link
- 18: second metal region
- 19: third metal region
- 20a, 20b: plane-to-plane contact portion
- 21: virtual spring
- 25: resin sheet
- 26: protective film
- 27: through-hole
- 28: via paste
- 29: protrusion
- 30: copper foil
- 31: Sn-Bi solder particle
- 32: curable resin component
- 41: wiring board

## Claims

1. A multilayer wiring board comprising:
at least one insulating resin layer;
a first copper wiring disposed on a first surface of the insulating resin layer;
a second copper wiring disposed on a second surface of the insulating resin layer; and
via-hole conductors provided in a manner such that they penetrate through the insulating resin layer and electrically connect the first copper wiring and the second copper wiring,
wherein the via-hole conductor comprises a metal portion and a resin portion,
the metal portion comprising:
a first metal region including a link of copper particles which serves as a path for electrically connecting the first copper wiring and the second copper wiring;
a second metal region mainly composed of at least one metal selected from the group consisting of tin, a tin-copper alloy, and a tin-copper intermetallic compound; and
a third metal region mainly composed of bismuth,
the copper particles forming the link are in plane-to-plane contact with one another,
at least one of the first copper wiring and the second copper wiring is in plane-to-plane contact with the copper particle,
a surface of the first or second copper wiring in plane-to-plane contact with the copper particle is roughened, and
a portion where the first or second copper wiring is in plane-to-plane contact with the copper particle is covered with at least a part of the second metal region.

2. The multilayer wiring board in accordance with claim 1, wherein at least a part of the portion where the copper particles are in plane-to-plane contact with each other is covered with the second metal region.

3. The multilayer wiring board in accordance with claim 1 or 2, wherein the proportion of the copper particles in the via-hole conductor is in the range of 30 to 90 mass%.

4. The multilayer wiring board in accordance with any one of claims 1 to 3, wherein the weight ratio between copper (Cu) and tin (Sn), represented by Cu/Sn, in the metal portion is in the range of 1.59 to 21.43.

5. The multilayer wiring board in accordance with any one of claims 1 to 4, wherein the first metal region and the third metal region are not in contact with one another.

6. A method for producing a multilayer wiring board,
the multilayer wiring board comprising: at least one insulating resin layer; a first copper wiring disposed on a first surface of the insulating resin layer; a second copper wiring disposed on a second surface of the insulating resin layer; and via-hole conductors provided in a manner such that they penetrate through the insulating resin layer, the via-hole conductors electrically connecting the first copper wiring and the second copper wiring,
wherein the via-hole conductor comprises a metal portion and a resin portion, the metal portion comprising: a first metal region including a link of copper particles for serving as a path which electrically connects the first copper wiring and the second copper wiring; a second metal region mainly composed of at least one metal selected from the group consisting of tin, a tin-copper alloy, and a tin-copper intermetallic compound; and a third region mainly composed of bismuth,
the copper particles forming the link are in plane-to-plane contact with one another,
at least one of the first copper wiring and the second copper wiring is in plane-to-plane contact with the copper particle, and
a portion where the first or second copper wiring is in contact with the copper particle is covered with at least a part of the second metal region,
the method comprising:
a first step of covering a surface of an insulating resin sheet with a protective film;
a second step of perforating the insulating resin sheet having the protective film thereon, so as to create through-holes;
a third step of filling the through-holes with a via paste containing copper particles, tin-bismuth solder particles, and a thermally curable resin;
a fourth step of removing the protective film after the third step to reveal protrusions each formed by a part of the via paste protruding from the through-hole;
a fifth step of disposing copper foil on at least one surface of the insulating resin sheet in a manner such that it covers the protrusions;
a sixth step of compression bonding the copper foil onto the insulating resin sheet and compressing the via paste by way of the protrusions, thereby: allowing the copper foil and the copper particles to come into plane-to-plane contact; and allowing the copper particles to come into plane-to-plane contact with one another to form a first metal region including a link of the copper particles; and
a seventh step of melting a part of the tin-bismuth solder particles in the via paste after the sixth step, at a temperature in a range from the eutectic temperature of the tin-bismuth solder particles to the eutectic temperature plus 10 °C, and then, heating further at a temperature in a range from the eutectic temperature plus 20°C to 300°C, thereby forming a second metal region and a third metal region.

7. A method for producing the multilayer wiring board in accordance with claim 6, wherein the thermally curable resin is an epoxy resin.
